# EUROPEAN PATENT SPECIFICATION

(11) **EP 0 405 996 B1**
(45) Date of publication and mention of the grant of the patent: **08.02.1995**
(21) Application number: 90307123.1
(22) Date of filing: 29.06.1990
(51) Int. Cl.: H01L 27/102

(54) **Method of manufacturing a bipolar semiconductor memory**
Verfahren zum Herstellen eines bipolaren Halbleiterspeichers
Procédé de fabrication d'une mémoire semi-conductrice bipolaire

(30) Priority: 29.06.1989 JP 169457/89
(43) Date of publication of application: 02.01.1991
(73) Proprietor: NEC CORPORATION, Tokyo (JP)
(72) Inventor: Nakamae, Masahiko, Minato-ku Tokyo 108-01 (JP)
(74) Representative: Moir, Michael Christopher

(56) References cited:
- EP-A- 0 084 500
- EP-A- 0 149 401
- PATENT ABSTRACTS OF JAPAN vol. 11, no. 346 (E-556)(2793) 12 November 1987 ; & JP-A-62 125 665
- IEEE INTERNATIONAL SOLID STATE CIRCUITS CONFERENCE, 26 February 1987, New York, US, pp. 130-131 ; Tomoharu Awaya et al. : "A 5NS Access Time 64KB ECL RAM".
- PATENT ABSTRACTS OF JAPAN vol. 12, no. 440 (E-684)(3287) 18 November 1988 ; & JP-A-63 170 956

## Description

### BACKGROUND OF THE INVENTION

The present invention relates to a method of forming a bipolar semiconductor memory, and more particularly a bipolar random access memory (hereinafter called bipolar RAM) used in a high speed computer. In a bipolar RAM of high-speed and high-integration density, research on transistor construction has been directed towards its miniaturization and its strong immunity against alpha (α) particles.

The inventor of the present invention has proposed a bipolar RAM, in which the base region of a vertical NPN transistor in the memory cell is made deeper than that of a vertical NPN transistor in the peripheral circuit, in order to improve the resistance to alpha particles in the memory cell with high speed characteristics in the peripheral circuit (Laid open Japanese Patent Application Disclosure Bulletin Serial No. 58-191465). In contrast, the construction of the vertical NPN transistor of the prior art memory cell is such that the base is in direct contact with the embedded collector region, as is described in an article in DIGEST OF TECHNICAL PAPERS, IEEE International Solid-State Circuits Conference, pp. 130-131 (1987).

In the conventional bipolar RAM of this kind, however, the impurity concentration of the P-type silicon substrate is determined in a range from 10¹⁴ to 10¹⁵ cm⁻³ mainly due to the speed improvement requirement of the peripheral circuit. The collector region of the vertical NPN transistor in the memory cell is embedded in the border between the P-type silicon substrate and the N⁻-type epitaxial layer, as is the vertical NPN transistor of the peripheral circuit. Accordingly, the depletion layer from the PN junction between the embedded collector region of the vertical NPN transistor in the memory cell and the P-type silicon substrate is largely extended into the P-type substrate. Consequently, collector-substrate capacitance at the memory cell becomes a small value and a large number of pairs of electrons and holes are apt to occur by alpha particles, and therefore, memory cells having a strong immunity against alpha particles cannot be attained which causes so called soft-errors. As a result, the conventional art can be applied to a bipolar RAM of up to 64 kilobits, but can not be applied to the higher capacity bipolar RAM, such as 256 kilobits, because further improvement in strong immunity against alpha particle characteristics so as to avoid soft error is necessary.

### BRIEF SUMMARY OF THE INVENTION

An object of the present invention is to provide a method of forming a bipolar semiconductor memory having a strong immunity against alpha (α) particles in a memory cell while maintaining the high speed characteristics of vertical transistors in a peripheral circuit.

JP-A-62-125665 discloses a method of forming a vertical transistor in a memory cell comprising forming a P-type impurity region of high impurity concentration by selectively diffusing P-type impurities into a P-type silicon substrate; depositing an N⁻-type epitaxial layer after introducing N-type impurities selectively into said P-type impurity region, which impurities subsequently form an N⁺-type embedded collector region in a border portion between said P-type impurity region of high impurity concentration and said N⁻-type epitaxial layer; forming a P-type base region.

The present invention is characterised by forming a device isolation region penetrating said N⁻-type epitaxial layer and said N⁺-type embedded collector region;
forming said P-type base region in contact with said N⁺-type embedded collector region by introducing a P-type impurity into a section of said N⁻-type epitaxial layer surrounded by said device isolation region;
forming an N⁺-type emitter region by introducing N-type impurity selectively into said P-type base region;
forming said P-type impurity region of high impurity concentration by ion-injection of P-type impurities followed by activation annealing so that a peak impurity concentration therein is disposed at a predetermined depth from a surface of said P-type silicon substrate; and
disposing a PN junction between said N⁺-type embedded collector region and said P-type impurity region of high impurity concentration at a position shallower than said position of peak impurity concentration.

The position of peak impurity concentration is chosen to be below the PN junction, and between the high impurity concentration embedded collector region of the vertical transistor in the memory cell and the high-impurity concentration region. This means that there is a barrier for electrons at the position of peak impurity concentration so that the electrons generated by alpha particle irradiation at a portion deeper than this peak impurity concentration position are prevented from flowing into collector parasitic capacitance.

### BRIEF DESCRIPTION OF THE DRAWINGS

The above-mentioned and other objects, features and advantages of this invention will become apparent with reference to the following detailed description of the method of the invention taken in conjunction with the accompanying drawings, wherein:
Fig. 1a is a circuit diagram showing a portion of a bipolar RAM, in particular the memory cell array and its peripheral circuit, which may be manufactured by the method of the present invention;
Fig. 1b is a circuit diagram of the memory cell of the bipolar RAM shown in Fig. 1a;
Fig. 2 is a plan view for explaining the device structure of a bipolar RAM manufactured by the present invention;
Figs. 3a and 3b are sectional views along single-dotted lines X-X′ and Y-Y′ in Fig. 2, respectively; and
Fig. 4 is a plan view showing schematically a section of a cell array;
Figs. 5a to 5d are sectional views for explaining the main processes of the fabrication method of the bipolar RAM of the present invention.

### DETAILED DESCRIPTION OF THE PREFERRED EMBODIMENT

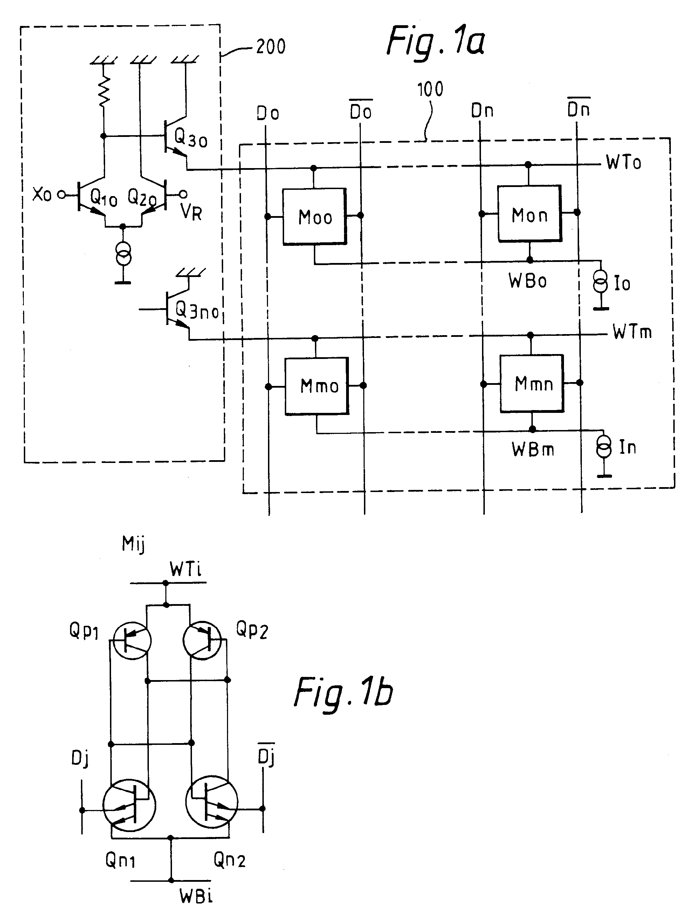

The circuit construction of a bipolar RAM will be explained using the memory cell in the bipolar RAM shown in Fig. 1a while referring to Fig. 1b.

In Fig. 1a, a memory cell array 100 of a bipolar RAM and a word line driver circuit 200 which is a portion of the peripheral circuit, are shown.

The memory cell array 100 includes a memory cell Mᵢⱼ, which is selected by a pair of word lines WTᵢ and WBᵢ (i = 0, 1, ... m), and a pair of digit lines Dⱼ and D̅ⱼ̅ (j = 0, 1, ... n). The word line is driven by the word line driver circuit 200. A word line WT₀ is connected to the emitter of an output transistor Q₃₀ of the word line driver circuit shown in Fig. 1a. The output transistor Q₃₀ is driven by an ECL gate composed of the common connection of the emitters of transistors Q₁₀ and Q₂₀. The output X₀ of a word address decoder (not shown) is applied to the base of transistor Q₁₀, while a reference voltage V_{R} is applied to the base of transistor Q₂₀. To the other word line WTₘ an output transistor Q₃ₘ is connected.

As is explained above, the peripheral circuit of a bipolar RAM includes a number of ECL gates.

Fig. 1b is a circuit diagram of a cross-coupled PNPN memory cell. One of the emitters of each of the multi-emitter NPN transistors Qₙ₁ and Qₙ₂ are commonly connected to a word line WBᵢ. The other of the emitters of each of the transistors Qₙ₁ and Qₙ₂ are connected to digit lines Dⱼ and D̅ⱼ̅, respectively. the base and collector of NPN transistor Qₙ₁ are connected to collector and base of PNP transistor Qₚ₁, respectively, while the base and collector of NPN transistor Qₙ₂ are connected to collector and base of PNP transistor Qₚ₂, respectively. Moreover, the base and collector of NPN transistor Qₙ₁ are connected to collector and base of NPN transistor Qₙ₂, respectively.

In the operating condition, a logical status is stored in the above-mentioned memory cell. In other words, one of the collectors of NPN transistors Qₙ₁ and Qₙ₂ is maintained to be high, while the other is maintained to be low. For example, assume that the collector of Qₙ₁ is high, while that of Qₙ₂ is low. This corresponds to the fact that the NPN transistor Qₙ₁ is off, while the NPN transistor Qₙ₂ is on. Accordingly, the PNP transistor Qₚ₁ is off, so that the base current supply of NPN transistor Qₙ₁ is shut off. Conversely, the NPN transistor Qₙ₂ is on, so that its emitter current flows to a constant current source Iᵢ through word line WBᵢ.

In order to change the logical status of the memory cell, the emitter current is forced to flow from the transistor of off-status, that is, NPN transistor Qₙ₁ in the above example, to the digit line Dⱼ. Consequently, NPN transistor Qₙ₁ becomes on, so that its collector voltage becomes low. Then, the PNP transistor Qₚ₁ becomes on. In turn, the collector of transistor Qₙ₂ becomes high, so that the transistors Qₚ₂ and Qₙ₂ become off. As a result, the collector of transistor Qₙ₁ is low, while the collector of transistor Qₙ₂ is high. Thus, the exchange of the logical status is completed.

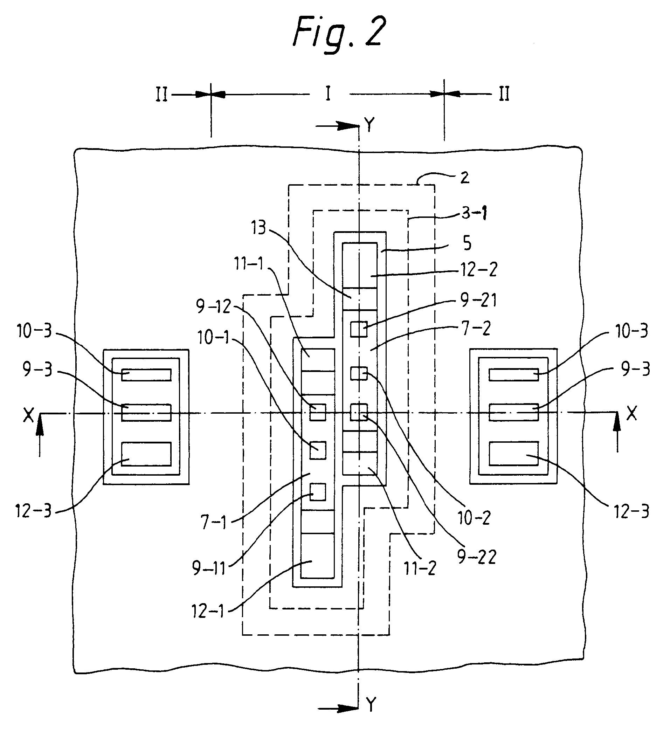

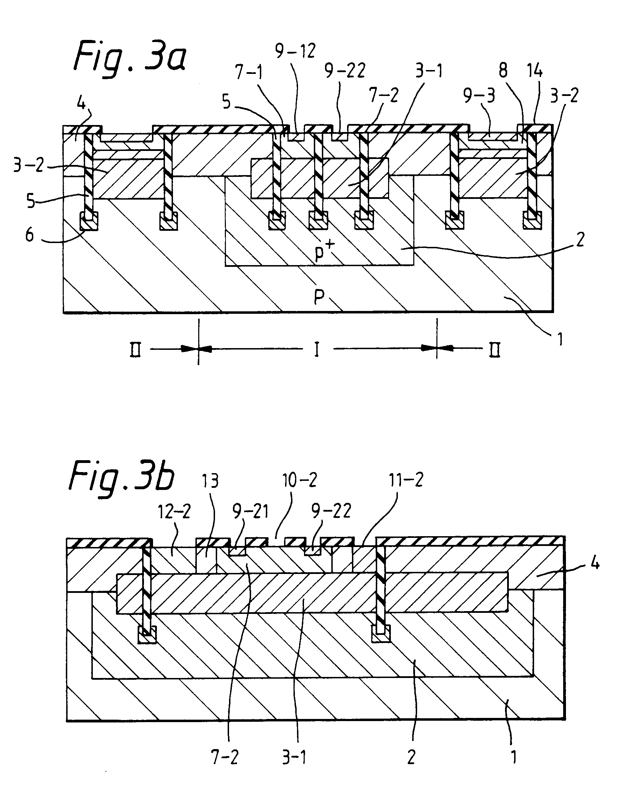

Next, a bipolar RAM of an embodiment of the present invention will be explained with reference to Fig. 2, Figs. 3a and 3b and Fig. 4. In Figs. 3a and 3b, the aperture of insulating film 14 and the active region under this aperture are shown to be nearly the same size for illustration convenience, but the size of the active region is, of course, slightly larger than that of the aperture. In Figs. 2 and 3a, only one memory cell is shown in a memory cell area I for simplicity, while the longitudinal NPN transistors are shown in the peripheral circuit areas II disposed at the left and right of area I.

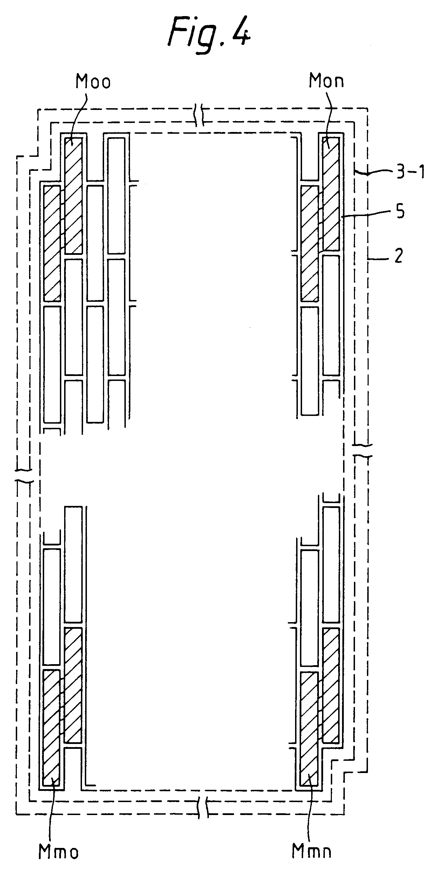

Fig. 4 represents a whole memory cell section constituted of a plurality of memory cells, region I shown in Fig. 2 and Figs. 3a and 3b, and the memory cells Mₒₒ, Mₒₙ, M_{MO} and M_{MM} positioned at the four corners are represented by right-upward hatching.

In this embodiment, the cross-coupled PNPN memory cell shown in Fig. 1b is used. In Figs. 2, 3a and 3b, the transistors of this cross-coupled PNPN memory cell are shown and the associated wirings are omitted. Each transistor is transversely isolated by means of an insulating film 5 deposited in trench isolator region. In the bottom of the insulator film 5, a channel stopper region 6 of P⁺-type is provided.

In the embodiment, the N⁺-type embedded collectors 3-1 and 3-2 of the vertical transistors are constructed in the border region between P-type silicon substrate 1 having an impurity concentration of about 10¹⁴ cm⁻³ and a N⁻-type epitaxial layer 4 deposited upon substrate 1. A P⁺-type diffusion region 2 having a peak impurity concentration of at least 10¹⁶ cm⁻³ is constructed so that a portion of it is in contact with the embedded collector 3-1 of longitudinal transistors Qₙ₁ and Qₙ₂ constituting a memory cell.

As shown in Fig. 4, the P⁺-type diffusion region 2 is common to all memory cells belonging to a cell array. In other words, all memory cells share a single P⁺-type diffusion region 2.

In the peripheral circuit area II, as is shown in Fig. 3a, a P-type base region 8 is deposited upon N⁻-type epitaxial layer 4 above N⁺-type embedded collector region 3-2 within the trench isolator region 5 in such a manner that region 8 does not reach the embedded collector region 3-2. Then, an N⁺-type emitter region 9-3 is deposited above region 8. The vertical NPN transistor of the peripheral circuit, such as transistors Q₁₀, Q₂₀ and Q₃₀ in Fig. 1a, contains a small base-collector capacitance constituted between P-type base region 8 and N⁻-type collector region (a portion of N⁻-type epitaxial layer 4) deposited between base region 8 and embedded N⁺-type collector region 3-2. Moreover, it also contains a small collector-substrate junction capacitance constituted between the bottom of N⁺-type embedded collector region 3-2 and P-type silicon substrate 1. Therefore, the vertical transistor for the peripheral circuit has a construction suitable for high speed operation.

In the memory cell area I, as is shown in Figs. 2, 3a and 3b, an N⁺-type embedded collector region 3-1 is disposed on P⁺-type diffusion region 2 within trench isolator region 5, while the P-type base regions 7-1 and 7-2 are disposed so that they cover the whole region of N⁻-type epitaxial layer 4 upon collector region 3-1. In other words, the upper surface of N⁺-type embedded collector region 3-1 is in contact with P-type base region 7-1 and 7-2 and the bottom is in contact with P⁺-type diffusion region 2. Upon P-type base regions 7-1 and 7-2, two N⁺-type emitter regions 9-11, 9-12 and 9-21, 9-22 are constructed, respectively. Two apertures 10-1 and 10-2 for base contacts of P-type base regions 7-1 and 7-2 are provided in the middle of the two N⁺-type emitter regions, respectively. As is shown in Figs. 2, the P-type regions 12-1 and 12-2 extending into the embedded collector region 3-1 are provided at one end of prolonged transistor regions, while then N⁺-type collector contact regions 11-1 and 11-2 extending into embedded collector region 3-1 are provided. Thus, the NPN transistor Qₙ₁ in Fig. 1b is composed of two emitter regions 9-11 and 9-12, base region 7-1, base contact aperture 10-1, collector region 3-1 and collector contact region 11-1, while another transistor Qₙ₂ is composed of two emitter regions 9-21 and 9-22, base region 7-2, base contact aperture 10-2, collector region 3-1 and collector contact region 11-2. The PNP transistors Qₚ₁ and Qₚ₂ are lateral transistors, which have the respective P-type emitter regions 12-1 and 12-2, N⁻-type base region 13. The collector regions of these transistors are the P-type base regions 7-1 and 7-2 of vertical transistors Qₙ₁ and Qₙ₂, respectively. The vertical transistors Qₙ₁ and Qₙ₂ for the memory cell have large base-collector junction capacitances constituted by direct contact between P-type base regions 7-1 and 7-2, and N⁺-type embedded collector region 3-2, and also large collector-substrate junction capacitance constituted by contact between the bottom of N⁺-type embedded collector region 3-1 and P⁺-type diffusion region 2. Therefore, the vertical NPN transistors Qₙ₁ and Qₙ₂ for the memory cell contain a structure having good anti-soft-error characteristics.

The position of peak impurity concentration of the P⁺-type diffusion region 2 is disposed at about 1.5 micrometers lower than the PN junction between N⁺-type embedded collector region 3-1 and P⁺-type diffusion region 2. Therefore, there is a potential barrier for electrons at this position of peak impurity concentration. This potential barrier prevents electrons generated below this peak position from invading the collector region of the NPN vertical transistor, with the result that the anti-soft-error characteristics is improved further.

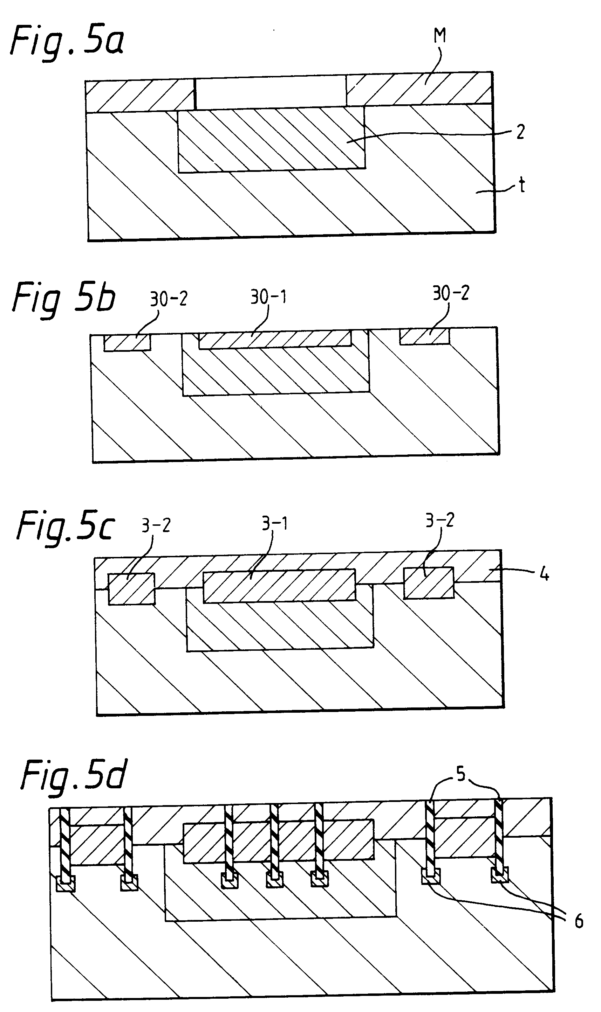

Now, the fabrication method for bipolar RAM of the embodiment of the present invention will be explained with reference to Figs. 5a to 5d.

As is shown in Fig. 5a, a photoresist mask M of 10 micrometers is deposited upon a P-type substrate 1 of 10¹⁴ cm⁻³ impurity concentration. Then, an aperture is selectively made in the mask M, to which the ion injection of boron with injection energy of 2 MeV is performed by a dose quantity in a range from 1 x 10¹³ cm⁻² to 5 x 10¹⁴ cm⁻², preferably 5 x 10¹⁴ cm⁻². Thereafter, the thermal treatment as an activation annealing is performed at 1000 °C for 30 minutes. Using a 5 x 10¹⁴ cm⁻² dose quantity and the thermal treatment, a P⁺-type diffusion region 2 containing 10¹⁹ cm⁻³ peak concentration at a depth of 3 micrometers is deposited. Succeedingly, as shown in Fig. 5b the N⁺-type regions 30-1 and 30-2 utilized for embedded collectors are selectively deposited on the main surface of P-type silicon substrate 1 by ion injection of arsenic. The injection energy is 150 KeV and the dose quantity is in the range from 1 x 10¹⁵ cm⁻² to 1 x 10¹⁶ cm⁻², preferably 5 x 10¹⁵ cm⁻². The N⁺-type regions 30-2 are formed in the positions at which P⁺ type region 2 is not deposited. Next, the thermal treatment is performed at 1000 °C for 6 hours. At that time, the surface of regions 30-1 and 30-2 on the P-type silicon substrate must be guarded by, for example, silicon oxide film (not shown).

Then, after removing the silicon oxide film, a N⁻-type epitaxial layer 4 of impurity concentration 10¹⁶ cm⁻³ is deposited with 1 micrometer thickness, as is shown in Fig. 5c. On this occasion, the regions 30-1 and 30-2 diffuse into the upper N⁻-type epitaxial layer 4 by about 0.4 micrometers to become the N⁺-type embedded collector regions 3-1 and 3-2. In the case where the dose quantity of arsenic is 5 x 10¹⁵ cm⁻² the position of the PN junction between N⁺-type collector region 3-1 and P⁺-type diffusion region 2 is lowered by about 1.5 micrometers from the border between P-type silicon substrate and N⁻-type epitaxial layer 4. Therefore, the position of this PN junction is shallower by about 1.5 micrometers from the position of peak impurity concentration of P⁺-type diffusion region 2.

Next, as is shown in Fig. 5d, the trench isolator regions 5 and the P⁺-type channel stoppers are formed resorting to prior art, so that a device isolator structure is constructed. Then, as is shown in Figs. 2, 3a and 3b, the P-type base regions 7-1 and 7-2, and the P-type emitter regions 12-1, 12-2 and 12-3 are selectively formed so as to contact with N⁺-type embedded collector region 3-1 and thereafter a shallow P-type base region 8 of peripheral circuit area II is selectively formed. Succeedingly, the N⁺-type collector contacts 11-1 and 11-2 are formed so as to contact with embedded collector region 3-1 and the shallow N⁺-type emitter regions 9-11, 9-12, 9-21, 9-22 and 9-3 are formed. After depositing an insulator film of, for example, silicon oxide, a base-contact hole 10-1 of transistor Qₙ₁, a base-contact hole 10-2 of transistor Qₙ₂, and a base-contact hole 10-3 of the peripheral circuit transistor are constructed. In this fabrication method, since the P⁺-type diffusion region is formed by means of high energy ion injection, the position of peak impurity concentration can be selected to be a deep position. Consequently, as is described above, the anti-soft-error characteristics can be improved further.

The soft-error rate of the bipolar RAM manufactured by the preferred method of the present invention specifically described herein is between ten and one hundred times lower than that of the conventional bipolar RAM composed of a memory cell and a peripheral circuit integrated on a P-type silicon substrate of the same impurity concentration.

Although the explanation is given about a bipolar RAM having a cross-coupled PNPN-type memory cell, the same can be applied to a bipolar RAM having a Schottky-diode clamped memory cell.

According to the present invention, as is explained above, a high-speed high-integration-density bipolar semiconductor memory device having a memory cell with a strong immunity against alpha (α) particles can be obtained by optimizing the volume of the depletion layer between the embedded collector of the memory cell and the substrate. Furthermore, by optimizing the volume of the depletion layer between the embedded collector of the peripheral circuit and the substrate the high-speed characteristics are maintained.

Although the invention has been described with reference to a specific embodiment, this description is not meant to be construed in a limiting sense. Various modifications of the disclosed embodiment will become apparent to persons skilled in the art upon reference to the description of the invention. It is therefore contemplated that the appended claims will cover any modifications or embodiments that fall within the true scope of the invention as defined by the claims.

## Claims

1. A method of forming a vertical transistor in a memory cell comprising:
forming a P-type impurity region (2) of high impurity concentration by selectively diffusing P-type impurities into a P-type silicon substrate (1);
depositing an N⁻-type epitaxial layer (4) after introducing N-type impurities selectively into said P-type impurity region, which impurities subsequently form an N⁺-type embedded collector region (3-2) in a border portion between said P-type impurity region of high impurity concentration and said N⁻-type epitaxial layer;
forming a P-type base region (7-1,7-2); and
characterised by
forming a device isolation region (5) penetrating said N⁻-type epitaxial layer and said N⁺-type embedded collector region;
forming said P-type base region (7-1,7-2) in contact with said N⁺-type embedded collector region (3-1) by introducing a P-type impurity into a section of said N⁻-type epitaxial layer surrounded by said device isolation region;
forming an N⁺-type emitter region (9-3) by introducing N-type impurity selectively into said P-type base region (7-1,7-2);
forming said P-type impurity region (2) of high impurity concentration by ion-injection of P-type impurities followed by activation annealing so that a peak impurity concentration therein is disposed at a predetermined depth from a surface of said P-type silicon substrate (1); and
disposing a PN junction between said N⁺-type embedded collector region (3-1) and said P-type impurity region of high impurity concentration (2) at a position shallower than said position of peak impurity concentration.

2. A method according to Claim 1, wherein said P-type impurities for forming said P-type impurity region (2) of high impurity concentration are boron; and wherein said N-type impurities for forming said N⁺-type embedded collector region are arsenic.

3. A method according to Claim 1 or Claim 2, wherein said device isolation region (5) is of a trench type.

## Patentansprüche

1. Verfahren zum Bilden eines Vertikaltransistors in einer Speicherzelle, das beinhaltet:
einen Störstellenbereich (2) vom P-Typ mit hoher Störstellenkonzentration durch selektives Diffundieren von Störstellen vom P-Typ in ein Siliciumsubstrat (1) vom P-Typ;
Aufbringen einer epitaxialen Schicht (4) vom N⁻-Typ nach Einbringen von Störstellen vom N-Typ selektiv in den Störstellenbereich vom P-Typ, welche Störstellen anschließend einen eingebetteten Kollektorbereich (3-2) vom N⁺-Typ in einem Grenzbereich zwischen dem Störstellenbereich vom P-Typ mit hoher Störstellenkonzentration und der epitaxialen Schicht vom N⁻-Typ bilden;
einen Basisbereich (7-1,7-2) vom P-Typ zu bilden; und,
das gekennzeichnet ist durch
einen Vorrichtungs- oder Bauelementisolationsbereich (5) auszubilden, der die epitaxiale Schicht vom N⁻-Typ und den eingebetteten Kollektorbereich vom N⁺-Typ durchdringt;
den Basisbereich (7-1,7-2) vom P-Typ in Berührung mit dem eingebetteten Kollektorbereich (3-1) vom N⁺-Typ durch Einfügen von Störstellen vom P-Typ in einen Bereich der epitaxialen Schicht vom N⁻-Typ, der von dem Bauelementisolierungsbereich umgeben ist, zu bilden;
einen Emitterbereich (9-3) vom N⁺-Typ zu bilden, indem Störstellen vom N-Typ selektiv in den Basisbereich (7-1, 7-2) vom P-Typ eingebracht werden;
den Störstellenbereich (2) vom P-Typ hoher Störstellenkonzentration durch Ioneninjektion von Störstellen vom P-Typ mit anschließendem Aktivierungstempern zu bilden, so daß die größte Störstellenkonzentration in einer vorbestimmten Tiefe von der Oberfläche des Siliciumsubstrats (1) vom P-Typ angeordnet ist; und
einen PN-Übergang zwischen dem eingebetteten Kollektorbereich (3-1) vom N⁺-Typ und dem Störstellenbereich vom P-Typ mit großer Störstellenkonzentration (2) an einer Stelle anzuordnen, die weniger tief ist als die Stelle der höchsten Störstellenkonzentration.

2. Verfahren nach Anspruch 1, bei dem die Störstellen vom P-Typ zum Bilden des Störstellenbereiches (2) vom P-Typ mit hoher Störstellenkonzentration Bor sind, und wobei die Störstellen vom N-Typ zum Bilden des eingebetteten Kollektorbereichs vom N⁺-Typ Arsen sind.

3. Verfahren nach Anspruch 1 oder 2, dadurch gekennzeichnet, daß der Bauelementisolationsbereich (5) vom Graben-Typ ist.

## Revendications

1. Procédé de fabrication d'un transistor vertical dans une cellule de mémoire, comprenant :
la formation d'une région d'impuretés de type P (2) à grande concentration en impuretés par la diffusion sélective d'impuretés de type P dans un substrat de silicium de type P (1) ;
le dépôt d'une couche épitaxiale de type N⁻ (4) après introduction sélective d'impuretés de type N dans ladite région d'impuretés de type P, ces impuretés formant ensuite une région de collecteur de type N⁺ noyée (3-2) dans une partie limite située entre ladite région d'impuretés de type P à grande concentration en impuretés et ladite couche épitaxiale de type N⁻ ;
la formation d'une région de base de type P (7-1, 7-2) ;
caractérisé par le fait que :
on forme une région isolante de dispositif (5) pénétrant dans ladite couche épitaxiale de type N⁻ et dans ladite région de collecteur de type N⁺ noyée ;
on forme ladite région de base de type P (7-1, 7-2) en contact avec ladite région de collecteur de type N⁺ noyée (3-1) en introduisant des impuretés de type P dans une partie de ladite couche épitaxiale de type N⁻ entourée par ladite région isolante de dispositif ;
on forme une région d'émetteur de type N⁺ (9-3) en introduisant sélectivement des impuretés de type N dans ladite région de base de type P (7-1, 7-2) ;
on forme ladite région d'impuretés de type P (2) à grande concentration en impuretés par injection d'ions d'impuretés de type P suivie d'un recuit d'activation, de telle sorte qu'une concentration en impuretés de pointe y est produite à une profondeur prédéterminée d'une surface dudit substrat de silicium de type P (1) ; et
on dispose une jonction PN entre ladite région de collecteur de type N⁺ noyée (3-1) et ladite région d'impuretés de type P à grande concentration en impuretés (2) à une position plus superficielle que ladite position de concentration en impuretés de pointe.

2. Procédé selon la revendication 1, dans lequel lesdites impuretés de type P destinées à former ladite région d'impuretés de type P (2) à grande concentration en impuretés sont du bore ; et dans lequel lesdites impuretés de type N destinées à former ladite région de collecteur de type N⁺ noyée sont de l'arsenic.

3. Procédé selon l'une quelconque des revendications 1 et 2, dans lequel ladite région isolante de dispositif (5) est de type à tranchées.
